(19) Europäisches Patentamt
European Patent Office
Office européen des brevets

(11) Publication number : **0 593 189 A1**

# (12) EUROPEAN PATENT APPLICATION

(21) Application number : **93307864.4**

(51) Int. Cl.[5] : **G03C 7/30**, G03F 3/10

(22) Date of filing : **04.10.93**

(30) Priority : **13.10.92 JP 274520/92**

(43) Date of publication of application :
**20.04.94 Bulletin 94/16**

(84) Designated Contracting States :
**DE FR GB NL**

(71) Applicant : **KONICA CORPORATION**
**26-2, Nishi-shinjuku 1-chome Shinjuku-ku**
**Tokyo 163 (JP)**

(72) Inventor : **Masumi, Satoshi**
**c/o Konica Corporation, 28 Horinouchi**
**Odawara-shi, Kanagawa-ken (JP)**
Inventor : **Takada, Shun**
**c/o Konica Corporation, 28 Horinouchi**
**Odawara-shi, Kanagawa-ken (JP)**

(74) Representative : **Brock, Peter William et al**
**URQUHART-DYKES & LORD 91 Wimpole Street**
**London W1M 8AH (GB)**

## (54) Silver halide color photosensitive material and color proof preparation process.

(57) A method for preparing a color proof is disclosed, wherein a silver halide color photographic photosensitive material comprising a reflective support having thereon a blue-sensitive layer, a green-sensitive layer and a red-sensitive layer is subjected to light exposure and processing based on halftone dot image information comprised of yellow, magenta, cyan and black image information, wherein at least one of the photosensitive layers has an average gradation of 1.7 to 2.8 between a density of a minimum density + 0.5 and a density of the minimum density + 1.1.

EP 0 593 189 A1

## Field of the Invention

This invention relates to a silver halide color photosensitive material and particularly to a silver halide color photosensitive material suitable for forming a color image for proofing use (so-called a color proof) from transmission type black-and-white half tone dot original documents each color-separated from a color original document. (The above-mentioned silver halide color photosensitive material is hereinafter referred to as a "color photosensitive material" or, simply, as a "photosensitive material").

## Background of the Invention

In the color plate-making·printing processes, as the processes for preparing a color proof from plural black-and-white half tone dot images each obtained by making a color-separation and a half tone dot image conversion, there have so far been the well-known overlay process and surprint process each for forming a color image by making use of a diazo compound and a photopolymer.

The above-mentioned overlay process has such an advantage that the operations are very simple, the preparation cost is inexpensive and when only superposing four color film sheets (in three primary colors of subtractive color mixture and in black), it can be used as a color proof. However, this process also has such an disadvantage that a gloss is produced by superposing the film sheets and a texture different from the subject printed matter is produced.

The above-mentioned surprint process is to superpose some colored images upon a support. The processes include those in which a colored image is obtained in a toner development by utilizing the tackiness of a photopolymeric material, about which are well-known in U.S. Patent Nos. 3,582,327, 2,607,264 and 3,620,726.

There are the well-known processes each for preparing a color proof such as those described in Japanese Patent Examined Publication (hereinafter referred to as JP Examined Publication) No. 47-27221/1972 and Japanese Patent Publication Open to Public Inspection (hereinafter referred to as JP OPI Publication) No. 56-501217/1981, in which after an image is transferred on a support by making use of a photosensitive colored sheet and the image is then formed by exposing it to light and developing it, another colored sheet is superposed thereon and the same processes are repeated, so that the color proof can be prepared.

There is also a well-known process for forming a color image on one support such as that described in JP OPI Publication No. 59-97140/1984, in which, by making use of photosensitive color sheets, the corresponding color-separated films are each exposed to light and developed, and the resulting each image is then transferred onto a support. The color tone of the resulting color proof can resemble that of the subject printing matter in tone, because any colorants similar to printing inks can be used as the toners for forming the above-mentioned images and the colorants applicable to the colored sheets.

In these processes, however, images are to be superposed or transferred in a color proof preparation process. Therefore, it takes a long time to carry out the processes and it also costs much to prepare a color proof.

For solving the above-mentioned disadvantages, JP OPI Publication Nos. 56-113139/1981, 56-104335/1981, 62-280746/1987, 62-280747/1987, 62-280748/1987, 62-280749/1987, 62-280750/1987 and 62-280849 disclose the processes each for preparing a color proof by making use of a silver-salt color photosensitive material.

In the above-mentioned techniques, a color image is formed in the following manner. Plural color-separated black-and-white half tone dot images converted from a colored original document into color-separated half tone dot images. The resulting plural color-separated black-and-white half tone dot images are each printed one after another on one sheet of color paper in a method such as a contact printing method. The resulting printed color paper is color-developed. The resulting color image formed of the dyes produced imagewise of couplers in the color development. And, the resulting color image is used as a proofing image.

In the color proof preparation processes to which color photosensitive materials are applied, various techniques for obtaining objective colors have been disclosed. For example, JP OPI Publication No. 53-141034/1978 describes a method in which a chromatic standard diagram is made out and an exposure time can be determined thereby. In this technique, however, the objective monochromatic densities of yellow, magenta and cyan colors may be obtained, but any color proof having an excellent blue- green- and red-color balance may not be obtained in an additive color process and the exposure method becomes complicated.

JP OPI Publication No. 56-104335/1981 discloses a color proof preparation process in which the overall photographic gradation of a color photosensitive material can be not less than 2.0. However, there is no description at all about the photographic gradation in the toe portions of yellow-, magenta- and cyan-color images and the balance of the photographic gradation thereof, but there is a description of Fuji Color Paper 08, Fuji Chrome Paper Type 31, Kodachrome 74RC which are being generally available on the market, as the concrete

examples of color photosensitive materials. In these color photosensitive materials, the balance of the photographic gradation in the toe portions are so designed as to make a print from a color film to a color paper, but they are not suitable for any color proof.

Further, JP OPI Publication No. 56-113139/1981 describes a color proof preparation process in which the comprehensive photographic gradation of a color photosensitive material is not less than 2.0 and other color components are contained in the resulting color proof. In this process, however, some arbitrary color is to be compensated, but there is no effect on any color balance.

In addition, JP OPI Publication No. 62-14651/1987 discloses that a mask having dots is used in an exposure making step. However, this process is to produce a density variation to an image having a fixed monochromic density, but is not any relation at all to a color balance.

Besides the above, JP OPI Publication No. 2-72349/1990 describes that a color proof improved in half tone dot reproduction can be obtained by uniforming the balance. There is some descriptions of half tone dot quality improvements, but no description of any dot gain.

Recently, there have been increasing applications not only to make a position proof for confirming the positions of letters and pictures, but also to make a tone proof for confirming a delicate shadow or color shade.

In a printing operation, half tone dots of a printed matter are made larger than those of an original document, because of a bleeding ink and so forth. The ratios of this ink bleeding is called a "dot gain". The so-called dot gain corresponds to a gradation in a general photograph and seriously affects an image quality. Therefore, it is necessary to control a dot gain to resemble a subject printed matter so that a high quality proof can be obtained.

For practical printing operation, a dot gain is controlled by adjusting an amount of ink used. In a toner type color proof, the dot gain is controlled by increasing an amount of toner used.

On the other hand, in a color proof applied with a color paper, the dot gain is controlled by adjusting an exposure amount. In this method, however, in the case of using a positive type color proof and when the dot gain is properly increased, the white background and image quality are both deteriorated; and, in the case of using a negative type color proof and when the dot gain is properly controlled, the density becomes out of the standard level and, when the density is properly adjusted, the dot gain becomes out of the standard level, because of the dilemma produced so that, when changing an exposure amount, a density is varied and vice versa.

The methods for controlling the above-mentioned dot gain by making use of the means other than exposure amounts include, for example, a method for controlling a dot gain by changing the sharpness of s photosensitive material. However, even in this method, the comprehensive image quality cannot be improved, because the reproducibilities of large and small dots are seriously deteriorated when trying to increase the dot gains in both of the positive and negative types.

## Summary of the Invention

It is, accordingly, an object of the invention to provide a silver halide color photographic photosensitive material in which the dot gain can be controlled without producing any deterioration of image quality, when the silver halide color photographic photosensitive material is used for preparing a color proof based upon a series of half tone dot image information obtained by carrying out a color-separation and a half tone dot image conversion; and a method for preparing the above-mentioned color proof in which the above-mentioned silver halide color photographic photosensitive material is used.

The above-mentioned objects of the invention can be achieved with a silver halide color photosensitive material comprising a reflection type support bearing thereon a blue-photosensitive layer, a green-photosensitive layer and a red-photosensitive layer, wherein at least one color image of the photosensitive layers, that is obtained by making an exposure to light and a development in a color image forming process, the color image has an average gradation within the range of 1.7 to 2.8 between a density of the minimum density (Dmin) + 0.5 and another density of the minimum density + 1.1; and the color proof preparation process comprising preparing a color proof, by making use of the above-mentioned color photosensitive material, based upon a series of halftone dot image information comprising each of color-separated yellow, magenta, cyan and black image information. From the viewpoint that the advantages of the invention can be further displayed, it is preferred that every reflection density of the color photosensitive material is not lower than 0.8 in each of the wavelengths of 450nm, 550nm and 700nm before developing the color photosensitive material.

## Detaile Description of the Invention

In the invention, the term, "an average gradation", is herein defined as a slope of a straight line obtained when connecting two points (a) and (b) corresponding to densities of Dmin + 0.5 and Dmin + 1.1 on a characteristic curve of the color photographic material.

In other words,

$$\text{an average gradation} = 0.6 / |b - a|$$

where a and b each represent an exposure amount in lagarithm.

In the invention, the reflection density of a photosensitive material is a value measured by making use of a color analyzer Model 607 manufactured by Hitachi, Ltd.

In the invention, the methods for making the reflection density set to be not lower than 0.8 in each of the wavelengths of 450nm, 550nm and 700nm before carrying out a development include a method for adding each of water-soluble yellow, magenta and cyan dyes and/or, preferably, another method for providing an antihalation layer to the lowermost layer.

It is preferred to make present the antihalation layer in the form of a non-photosensitive hydrophilic colloidal layer. In this layer, the water-soluble dyes and/or non-photosensitive colloidal silver can be contained.

The water-soluble yellow, magenta and cyan dyes each applicable to the invention include, for example, an oxonol dye, a cyanine dye, a merocyanine dye, an azo dye, an anthraquinone dye and an allylidene dye. Among them, an oxonol dye and a merocyanine dye are particularly preferable, from the viewpoints of the high decomposition property required in developers and the non-color sensitization property required to silver halide emulsions.

The above-mentioned oxonol dyes are described in, for example, U.S. Patent No. 4,187,225, and JP OPI Publication Nos. 48-42826/1973, 49-5125/1974, 49-99620/1974, 50-91627/1975, 51-77327/1976, 55-120660/1980, 58-24139/1983, 58-143342/1983, 59-38742/1984, 59-111640/1984, 59-111641/1984, 59-168438/1984, 60-218641/1985, 62-31916/1987, 62-66275/1987, 62-66276/1987, 62-185755/1987, 62-273527/1987 and 63-139949/1988. The merocyanine dyes are described in, for example, JP OPI Publication Nos. 50-145124/1975, 58-120245/1983, 63-35437/1988, 63-35438/1988, 63-34539/1988 and 63-58437/1988.

In the invention, the water-soluble dyes are to be added in such an amount that each reflection density can be not lower than 0.8 in the wavelengths of 450nm, 550nm and 700nm before developing a subject color photosensitive material. Each of the reflection density is preferably within the range of 0.9 to 1.2.

In the invention, the water-soluble dyes are to be contained in a photosensitive silver halide emulsion layer and/or a non-photosensitive layer.

In the invention, the water-soluble dyes are to be used in the combination of yellow, magenta and cyan dyes. Each of the water-soluble yellow, magenta and cyan dyes may be used independently or in combination.

Each of the emulsion layers of the photosensitive materials of the invention contains an nondiffusible coupler capable of producing a dye upon coupling reaction with the oxidized products of an aromatic primary amine compound (such as a p-phenylene diamine derivative and an aminophenol derivative) in the course of carrying out a development process.

The yellow couplers include, preferably, acylacetanilide type couplers and, among them, a benzoyl acetanilide type coupler and a pivaloyl acetanilide type coupler can advantageously be used. The particularly preferable compounds are those having the following formula (Y).

Formula (Y)

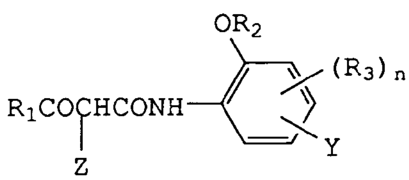

wherein $R_1$ represents an alkyl, cycloalkyl or aryl group; $R_2$ represents an alkyl, cycloalkyl, acyl or aryl group; $R_3$ represents a group substitutable to a benzene ring; n is an integer of 0 or 1; Z represents a hydrogen atom or a group capable of splitting off upon reaction with the oxidized products of a color developing agent; and Y represents an organic group.

The above-mentioned yellow couplers include, typically, compounds Y-I-1 through Y-I-51 given in JP OPI Publication No. 3-39958/1991, pp. (7) ~ (10). Besides, the following couplers may also preferably be used.

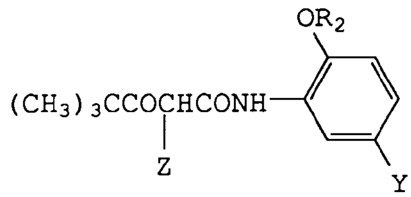

| No. | $R_2$ | Z | Y |
|---|---|---|---|
| Y-1 | $-C_{16}H_{33}$ | 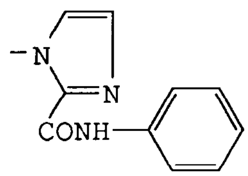 | $-SO_2NHCOC_2H_5$ |
| Y-2 | $-CH_3$ | 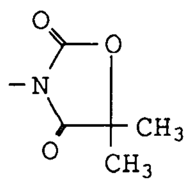 | $-COOC_{14}H_{29}$ |
| Y-3 | $-CH_3$ | 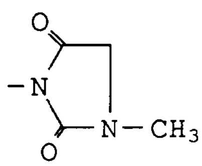 | $-NHCOCHCH_2SO_2C_{12}H_{25}$<br>$CH_3$ |
| Y-4 | $-CH_3$ | 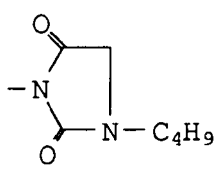 | $-NHCOCHCH_2SO_2C_{12}H_{25}$<br>$CH_3$ |
| Y-5 | $-CH_3$ | 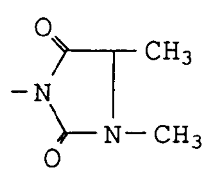 | $-NHCOCHCH_2SO_2C_{12}H_{25}$<br>$CH_3$ |
| Y-6 | $-CH_3$ | 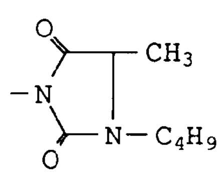 | $-NHCOCHCH_2SO_2C_{12}H_{25}$<br>$CH_3$ |

The magenta couplers applicable thereto include, for example, those of the 5-pyrazolone type, pyrazoloazole type, pyrazolinobenzimidazole type, indazolone type and acylacetonitrile type. These couplers are described in, for example, U.S. Patent Nos. 2,600,788, 3,062,653, 3,512,896, 3,558,318 and 3,930,866; and JP OPI Publication Nos. 49-29639/1974 and 50-13041/1975. Among them, the pyrazoloazole type magenta couplers such as those represented by the following Formula (M) are preferably used.

Formula (M)

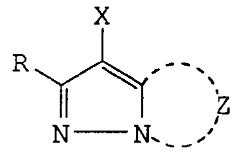

wherein Z represents a group consisting of non-metal atoms necessary to form a nitrogen-containing heterocyclic ring, provided, the rings each formed of the Z may have a substituent; X represents a hydrogen atom or a group capable of splitting off upon reaction with the oxidized products of a color developing agent; and R represents a substituent.

The examples of the compounds preferably applicable to the invention include those described in JP OPI Publication No. 3-163444/1991, the 3rd line of p.5 to the 16th line on p.30. The typical examples of the above-mentioned magenta couplers include those No.1 through No.61 given in the above-mentioned JP OPI Publication, pp.16 ~ 29. In addition, the couplers No. M-1 through M-41 given in JP OPI Publication No. 2-208653/1990, pp.34 ~ 58 may also be included in the examples thereof.

The cyan couplers generally applicable thereto include, for example, phenol or naphthol type couplers. These couplers are described in, for example, U.S. Patent Nos. 2,369,992, 2,434,272, 2,698,974, 3,034,892 and 3,839,044; and JP OPI Publication Nos. 47-3742/1972, 50-112038/1975, 50-130441/1975 and 2-251845/1990.

The typical examples of the above-mentioned cyan couplers include the couplers No.I-1 through No.I-31 given in JP OPI Publication No. 2-251845/1990, the upper left column on p.4 through the lower left column on p.5, and the couplers No.II-1 through No.II-20 given in the same JP OPI Publication, the upper right column on p.6 through the upper left column on p.7. Further, the typical examples of the cyan couplers including the above-given couplers, each applicable to the invention, are described in JP Examined Publication No. 49-11572/1974, JP OPI Publication Nos. 61-3142/1986, 61-9652/1986, 61-39045/1986, 61-50136/1986, 61-9914/1986 and 61-105545/1986, and so forth. Among these couplers, diacylamino phenol type cyan couplers are preferably used.

The couplers of the invention can be contained in photosensitive materials in any one of various methods. For example, the couplers can be contained therein by dissolving them in a high boiling organic solvent (such as a phthalic acid ester, a phosphoric acid ester, a phenol derivative and alkylamide) and then by emulsifying them, so that they can be used. The preferable high boiling organic solvents include, for example, the compounds given in JP OPI Publication Nos. 63-231340/1988, 63-241547/1988, 63-253943/1988 and 64-11262/1989. Among them, the particularly preferable compounds include those represented by the following Formula (HB).

Formula (HB)

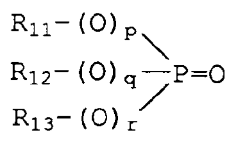

wherein $R_{11}$, $R_{12}$ and $R_{13}$ represent each an alkyl, cycloalkyl or aryl group; and p, q and r are each an integer of 0 or 1.

These high boiling organic solvents are preferable to be used in an amount within the range of 10 to 500 wt% to the couplers used. When dissolving the couplers of the invention in the above-mentioned high boiling organic solvents, a low boiling organic solvent may also additionally be used. It is also allowed to provide a process for removing the above-mentioned low boiling organic solvent. It is further allowed to use an emulsifier when making the emulsification and dispersion. It is still further allowed to contain a color tone controller.

The silver halides applicable to the photosensitive material of the invention include any one of those applicable to any conventional silver halide emulsions, such as silver bromide, silver iodobromide, silver chloroiodide, silver chlorobromide and silver chloride.

As for the processes for forming silver halide grains, any one of an acidic process, a neutral process and an ammoniacal process. For these processes, the processes well-known in the photographic field can be used,

such as a double-jet precipitation process, a normal precipitation process, a reverse precipitation process and a conversion process.

The silver halide grains may have a regular crystal form such as a cube, an octahedron and a tetradecahedron, or may have an irregular crystal form such as the globular-shaped and the tabular-shaped. The grains may also have the complexes of the above-mentioned crystal forms or may have the mixtures of variously formed grains.

The silver halide emulsions applicable thereto may have a relatively wide range of the grain size distribution (that is called a polydisperse type emulsion) or may have a relatively narrow range of the grain size distribution (that is called a monodisperse type emulsion). The preferable silver halide emulsions are of the monodisperse type (having a variation coefficient of not more than 0.20 = the standard deviation of a grain size distribution / an average grain size). The grain size thereof is preferably within the range of 0.1 to 1.0μm.

In an ordinary process, the silver halide emulsions can be chemically sensitized (for example, in a sulfur sensitization, a gold sensitization, a noble-metal sensitization, a selenium sensitization and a reduction sensitization) and they can also be spectrally sensitized (made by a cyanine dye, a merocyanine dye, a hemicyanine dye, a styryl dye or a hemioxonol dye). It is also allowed to add an antifoggant or a stabilizer (such as an azaindene and a mercapto heterocyclic compound) each known in the art.

It is also allowed to add a UV absorbent of the benzophenone type or the benzotriazole type into photosensitive materials. Among them, particularly, it is preferable to use the benzotriazole type compounds such as those described in, for example, U.S. Patent Nos. 3,754,919 and 4,220,711 and JP Examined Publication Nos. 42-26187/1967, 48-5496/1973 and 48-41572/1973. The typical examples thereof include the exemplified compounds IIIc-1 through IIIc-17 given in JP OPI Publication No. 1-250944/1989, p.389; the exemplified compounds III-1 through III-24 given in JP OPI Publication No. 64-66646/1989, p.413; the exemplified compounds UV-1L through UV-27L given in JP OPI Publication No. 63-187240/1988, p.283; and the exemplified compounds UV-1L through UV-22L given in JP OPI Publication No. 63-250647/1988, p.349 and UV-1S through UV-19S given in, ibid., p.350.

The above-mentioned dye forming couplers and hydrophobic compounds such as a UV absorbent are usually dissolved with a high boiling organic solvent (such as phthalates, phosphates, phenol derivative, alkylamide and cycloalkane) and, if required, a low boiling and/or water-soluble organic solvent in combination and the resulting solution is emulsified and dispersed by a binder (such as gelatin and other hydrophilic colloids) containing a surfactant, so that the resulting emulsion is then used.

Various kinds of photographic additives may be contained in the emulsion side of an emulsion layer and an auxiliary layer. For example, a color-image stabilizer, a color-contamination preventive, a fluorescent whitening agent, an antistatic agent, a hardener, a surfactant, a plasticizer, a wetting agent and so forth may suitably be used therein, as described in Research Disclosure No. 17643.

As for the methods for coating an emulsion layer and a component layer, a slide-hopper coating method, a curtain-coating method, an air-doctor coating method and so forth are useful. Among these methods, a simultaneous multilayer coating method carried out by making use of a slide-hopper is preferred.

The light sources applicable to make an exposure in the invention include, for example, natural light, a tungsten electric lamp, a fluorescent lamp, a mercury lamp and a halogen lamp. Among these lamps, a fluorescent lamp is preferably used, because it generates relatively low heat and an exposure means can be made smaller in size when making a scanning exposure.

In the invention, a color development process is carried out in the order of a color developing step, a bleach-fixing step and a washing step or a stabilizing step, each of which are well-known in the art.

Besides the above, a positive image can be obtained by using a reversal process such as a fogging process in direct positive color photosensitive materials, and by making combination use of the above-mentioned process and a primary black-and-white developing process in a reversal color photosensitive material.

The color developing agents applicable to color photosensitive materials include, typically, an aromatic primary amine and, concretely, those given below. Among them, CD-2 is preferably used.

CD-1

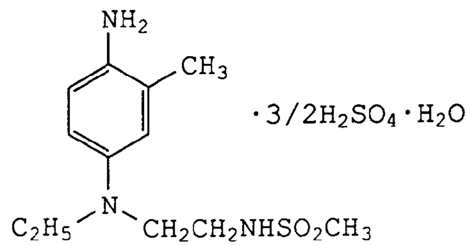

CD-2

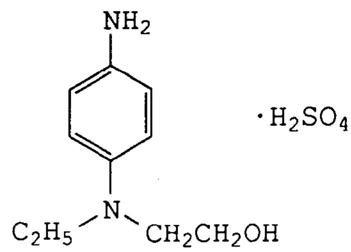

CD-3

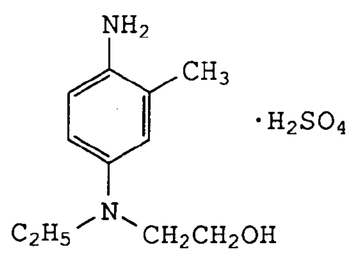

CD-4

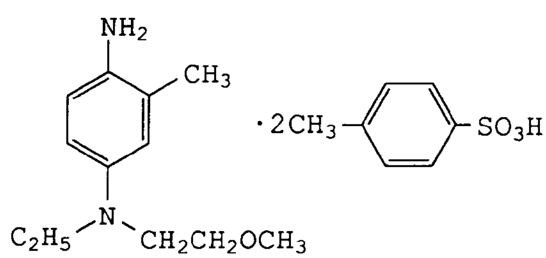

CD-5

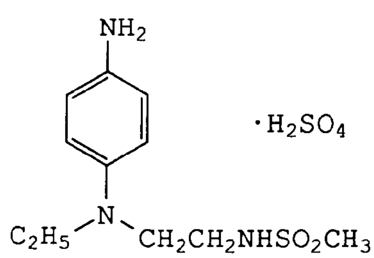

The above-mentioned color developing agents may each be added in an amount of not less than 0.01 mols per liter of a developer used and, preferably, in an amount within the range of 0.015 to 0.03 mols.

Color developers may be added by any well-known alkalizers, preservatives, antifoggants, fluorescent whitening agents, defoamers, development accelerators and so forth.

There is no special limitation to the color developing time. However, it takes ordinarily 30 seconds to 4 minutes. The temperatures of the developers are ordinarily within the range of 20 to 45°C.

As for bleach-fixers, any well-known bleachers and fixers may be used.

As for the binders (or protective colloids) applicable to the photosensitive materials of the invention, gelatin may advantageously be used. Besides the gelatin, it is also allowed to use hydrophilic colloids including, for example, a gelatin derivative, a graft polymers of gelatin and other high polymers, protein, a sugar derivative, a cellulose derivative and a synthetic hydrophilic high polymer substance such as mono- or co-polymers.

The photographic emulsion layers and other hydrophilic colloidal layers of photosensitive materials are hardened by cross-linking binder molecules and then by making independent or combination use of layer hardeners capable of enhancing the layer hardness. Such layer hardeners are preferably added in such an amount that the layers of photosensitive materials can be hardened, but any more layer hardener is not needed to add into a processing solution. However, such a layer hardener may also be added into the processing solution. The above-mentioned hydrophilic colloidal layers such as protective layers and interlayers are also allowed to contain UV absorbents for preventing any fogs produced on photosensitive materials by a static charge generated by a friction or the like and for preventing also any image deterioration produced by UV rays.

The photosensitive materials of the invention are allowed to be provided with auxiliary layers such as a filter layer, an antihalation layer and/or an anti-irradiation layer. These layers and/or emulsion layers are also allowed to contain therein a dye capable of flowing out of or being beached in a color photosensitive material during the course of carrying out a development process.

The silver halide emulsion layers and/or other hydrophilic colloidal layers are each allowed to contain a matting agent, for the purposes of reducing the gloss of photosensitive material, increasing retouchability, preventing the adhesion to each other photosensitive material. Besides, a lubricant may also be added thereto for reducing any sliding friction.

The photosensitive materials are also allowed to contain an antistatic agent for preventing any static charge. Such antistatic agents may sometimes be used in a component layer provided to the support side not laminated with any emulsion, or may also be used in a protective layer other than the emulsion layers provided to the support side laminated with the emulsion layers.

The photographic emulsion layers and/or other hydrophilic colloidal layers are applied with various surfactants, for the purposes of improving the layer coatability, preventing any static charge generation, improving the lubricity, improving the emulsification and dispersion properties, preventing any adhesion, improving the photographic characteristics (such as development acceleration, layer hardening and sensitizing) and so forth.

The photographic emulsion layers and other layers of the photosensitive materials of the invention can be provided to the following supports; paper supports comprising baryta paper or an α-olefin polymer laminated paper, from which the paper support and the α-olefin layer can readily be separated each other; flexible reflection type supports such as a synthetic paper; film-made supports comprising semisynthetic or synthetic high molecular compounds such as cellulose acetate, cellulose nitrate, polystyrene, polyvinyl chloride, polyethylene terephthalate, polycarbonate and polyamide; a reflection type supports coated with a white pigment; rigid materials such as glass, metal and earthenware. Besides, these layers can also be provided to thin reflection type supports having a thickness within the range of 120 to 160μm.

The supports applicable to the invention are to contain a white pigment therein for providing a reflection property, or the supports are each to be coated with a hydrophilic colloidal layer containing a white pigment.

The white pigments applicable thereto include, for example, inorganic and/or organic white pigments and, preferably, inorganic white pigments. The concrete examples thereof include the sulfates of alkaline earth metals such as barium sulfate, the carbonates of alkaline earth metals such as calcium carbonate, finely powdered silicic acid, silicas of synthetic silicates, calcium silicate, alumina, alumina hydrates, titanium oxide, zinc oxide, talc, and clay. Among them, the particularly preferable white pigments include barium sulfate and titanium oxide.

Is also allowed if required that the surface of a support is corona discharged, irradiated by UV rays or flame treated, and then a photosensitive material may be coated thereon directly or through a under-coat layer (that is, a single or plural under-coat layers with the purpose of improving the characteristics of the support surface, such as adhesive property, antistatic property, dimensional stability, antifrictional property, hardness, antihalation property, friction property and/or other characteristics).

When coating a photosensitive material, a thickener may be used for improving coatability. As for the coating methods, an extrusion coating method and a curtain coating method are particularly advantageous, because two or more layers can be coated at the same time.

In the invention, the processing can be made with a processing solution having a bleaching function and

a processing solution having a fixing function, immediately after completing a color development. It is also allowed to process with a processing solution having both bleaching function and fixing function (that is called a bleach-fixer). As for the bleachers applicable to the above-mentioned bleaching treatment, the metal complex salts of organic acids are used.

## EXAMPLES

The invention will now be further detailed below by citing the following examples. It is, however, to be understood that the invention shall not be limited thereto.

### Example 1

A positive type photosensitive material for color proofing use was prepared by coating the following layers 1 through 10 on the front surface of the (110μm-thick) paper support coated with polyethylene containing titanium oxide and then by coating a backing layer on the back surface thereof coated with polyethylene, respectively. The resulting photosensitive material is herein called Sample P-1.

The amounts of the additives coated thereon are indicated by $g/m^2$, and the amounts of the silver halide emulsions used therein are indicated by the amounts converted into the silver contents thereof.

| Layer | Composition | Amount coated |
|---|---|---|
| Layer 10 (A UV absorbing layer) | | |
| | Gelatin | 0.78 |
| | UV absorbent (UV-1) | 0.065 |
| | UV absorbent (UV-2) | 0.195 |
| | Solvent (SO-2) | 0.1 |
| | Colloidal silica | 0.03 |
| Layer 9 (A blue-sensitive layer) | | |
| | Gelatin | 1.43 |
| | Blue-sensitive silver chlorobromide emulsion spectrally sensitized with sensitizing dye (D-1); (containing Br=80 mol%, Cl=20 mol%) | 0.5 |
| | Yellow coupler (Y-1) | 0.82 |
| | Antistaining agent (HQ-1) | 0.025 |
| | Solvent (SO-1) | 0.82 |
| | Inhibitors (ST-1, ST-2, T-1) | |
| Layer 8 (An interlayer) | | |
| | Gelatin | 0.54 |
| | Antistaining agent (HQ-2) | 0.055 |
| | Solvent (SO-2) | 0.072 |
| Layer 7 (A yellow colloidal layer) | | |
| | Gelatin | 0.42 |
| | Yellow colloidal silver | 0.1 |
| | Antistaining agent (HQ-2) | 0.04 |
| | Solvent (SO-2) | 0.049 |
| | Polyvinyl pyrrolidone (PVP) | 0.047 |

| | |
|---|---|
| Layer 6 (An interlayer) | |
| Gelatin | 0.54 |
| Antistaining agent (HQ-2) | 0.055 |
| Solvent (SO-2) | 0.072 |
| Layer 5 (A green-sensitive layer) | |
| Gelatin | 1.43 |
| Green-sensitive silver chlorobromide emulsion spectrally sensitized with sensitizing dye (D-2); (containing Br=80 mol%, Cl=20 mol%) | 0.50 |
| Magenta coupler (M-1) | 0.25 |
| Antistaining agent (HQ-1) | 0.019 |
| Solvent (SO-1) | 0.31 |
| Anti-irradiation dye (AI-1) | 0.01 |
| Inhibitors (ST-1, ST-2, T-1) | |
| Layer 4 (An interlayer) | |
| Gelatin | 0.75 |
| Antistaining agent (HQ-2) | 0.055 |
| Solvent (SO-2) | 0.072 |
| Layer 3 (A red-sensitive layer) | |
| Gelatin | 1.38 |
| Red-sensitive silver chlorobromide emulsion spectrally sensitized with sensitizing dye (D-3); (containing Br=80 mol%, Cl=20 mol%) | 0.30 |
| Cyan coupler (C-1) | 0.44 |
| Solvent (SO-1) | 0.31 |
| Antistaining agent (HQ-1) | 0.015 |
| Anti-irradiation dye (AI-2) | 0.01 |

Inhibitors (ST-1, ST-2, T-1)

Layer 2 (An interlayer)

| | |
|---|---|
| Gelatin | 0.54 |
| Antistaining agent (HQ-2) | 0.055 |
| Solvent (SO-2) | 0.072 |

Layer 1 (An antihalation layer)

| | |
|---|---|
| Gelatin | 0.6 |
| Black colloidal silver | 0.10 |

Wherein SA-1 and SA-2 were each used for the coating aids and H-1 was used for the layer hardener. The chemical structures of the compounds used therein will be given below.

SO-1 : Trioctyl phosphate
SO-2 : Dioctyl phthalate
HQ-1 : 2,5-di-t-butyl hydroquinone
HQ-2 : 2,5-di-t-octyl hydroquinone
ST-1 : 1-(3-acetamido) phenyl-5-mercaptotetrazole
ST-2 : N-benzyl adenine
SA-1 : Sodium (2-ethylhexyl) sulfosuccinate
SA-2 : Sodium (2,2,3,3,4,4,5,5-octafluoropentyl) sulfosuccinate
T-1 : 4-hydroxy-6-methyl-1,3,3a,7-tetrazaindene
H-1 : Sodium 2,4-dichloro-6-hydroxy-s-triazine

Y-1

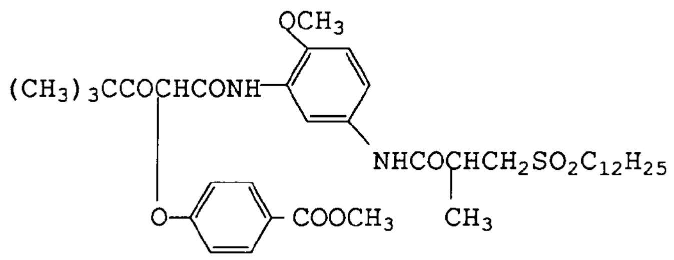

M-1

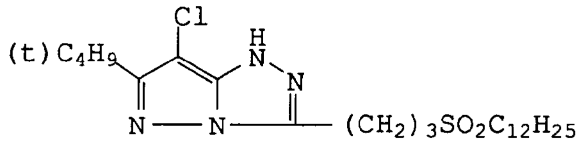

C-1

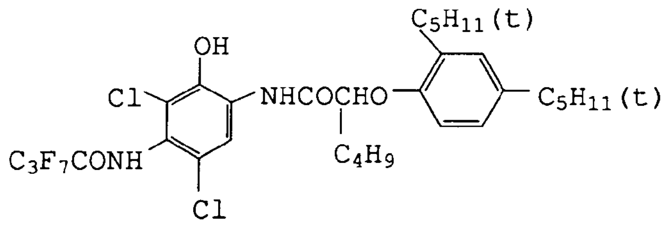

UV-1

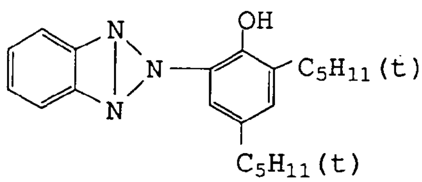

UV-2

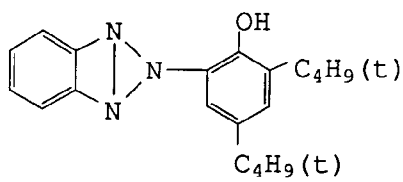

D-1

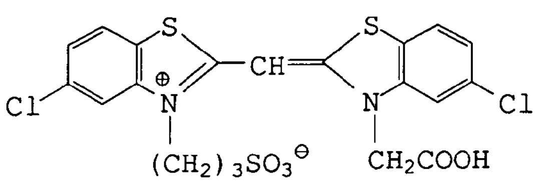

D-2

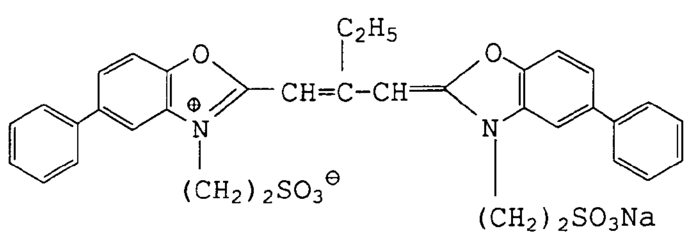

D-3

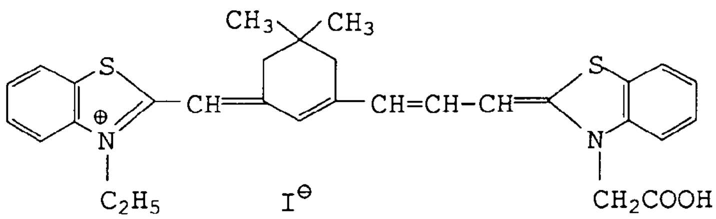

AI-1

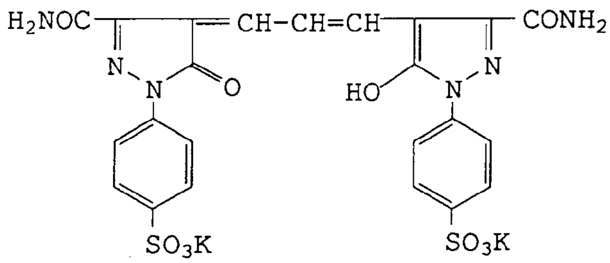

AI-2

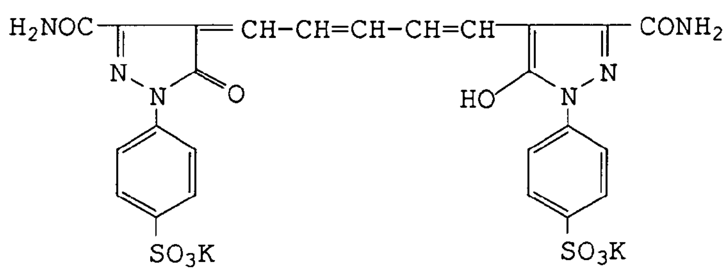

In Sample P-2, reflection densities were so controlled as to be relatively lowered by adjusting the colloidal silver content thereof, as compared to Sample P-1.

In Sample P-3, the gradation was so controlled as to be relatively softened by adjusting the amounts of both silver coated and coupler used respectively, as compared to Sample P-1. In addition, Samples P-4 through P-7 were each prepared by varying the average gradations of the blue-, green- and red-photosensitive layers as shown in Table 1, respectively.

The resulting Samples P-1 through P-7 were brought into close contact with black and cyan printers each out of a half tone dot original document and were then exposed to light under the following exposure conditions-1, respectively. Next, black and cyan printers were brought into close contact with each of the samples and were then exposed to light under the following exposure conditions-2, respectively. Further, black and yellow printers were brought into close contact with each of the samples and were then exposed to light under the following exposure conditions-3, respectively.

Each of the exposed samples was processed in the following processing steps and the resulting dye image densities were measured. Table 1 shows the results of the densities, dot gains and white backgrounds. In the density measurements, the resulting gradations were measured by a densitometer, Model PD-84 manufactured by Konica Corp. and the other measurements were made by a densitometer manufactured by X-rite Co. Further, the filter compensations were made by Status T.

(Exposure conditions-1)

When each of the photosensitive materials was exposed to white light through a red filter (Wratten No.26)

and an ND filter, the exposure was made for 0.5 seconds in the lowest possible exposure amount upon adjusting the density of the ND filter so that the lowest red light density could be obtained after developing the photosensitive material.

(Exposure conditions-2)

When each of the photosensitive materials was exposed to white light through a green filter (Wratten No.58) and an ND filter, the exposure was made for 0.5 seconds in the lowest possible exposure amount upon adjusting the density of the ND filter so that the lowest green light density could be obtained after developing the photosensitive material.

(Exposure conditions-3)

When each of the photosensitive materials was exposed to white light through a blue filter (Wratten No.47B) and an ND filter, the exposure was made for 0.5 seconds in the lowest possible exposure amount upon adjusting the density of the ND filter so that the lowest blue light density could be obtained after developing the photosensitive material.

A daylight type white fluorescent lamp was used as the light source for the exposure conditions-1 through -3.

The processing steps will be shown below. In the processing steps, the surfaces of the photosensitive materials were uniformly fogged by exposing them to light through a 3mm-thick developer layer, as they remained dipped in a developer.

| Processing steps-1 | Temperature | Time |
|---|---|---|
| Dipping (in a developer) | 37°C | 12 sec. |
| Fogging exposure | — | 12 sec. (1 lux) |
| Developing | 37°C | 95 sec. |
| Bleach-fixing | 35°C | 45 sec. |
| Stabilizing | 25 ~ 30°C | 90 sec. |
| Drying | 60 ~ 85°C | 40 sec. |

The compositions of the processing solutions were as follows.

(Color developer)

| | |
|---|---|
| Benzyl alcohol | 15.0 cc |
| Cerium sulfate | 0.015 g |
| Ethylene glycol | 8.0 cc |
| Potassium sulfite | 2.5 g |
| Potassium bromide | 0.6 g |
| Sodium chloride | 0.2 g |

| | |
|---|---|
| Potassium carbonate | 25.0 g |
| T-1 | 0.1 g |
| Hydroxylamine sulfate | 5.0 g |
| Sodium diethylenetriamine pentaacetate | 2.0 g |
| 4-amino-N-ethyl-N-(β-hydroxyethyl) aniline sulfate | 4.5 g |
| Fluorescent whitening agent, (a 4,4'-diaminostilbene disulfonic acid derivative) | 1.0 g |
| Potassium hydroxide | 2.0 g |
| Diethylene glycol | 15.0 cc |
| Add water to make in total | 1 liter |
| Adjust pH to be | pH 10.15 |

(Bleach-fixer)

| | |
|---|---|
| Ferric ammonium diethylenetriamine pentaacetate | 90.0 g |
| Diethylenetriamine pentaacetic acid | 3.0 g |
| Ammonium thiosulfate, (in an aqueous 70% solution) | 180 cc |
| Ammonium sulfite, (in an aqueous 40% solution) | 27.5 cc |
| 3-mercapto-1,2,4-triazole | 0.15 g |
| Adjust pH with potassium carbonate or glacial acetic acid to be | pH 7.1 |
| Add water to make in total | 1 liter |

(Stabilizer)

| | |
|---|---|
| o-phenyl phenol | 0.3 g |
| Potassium sulfite | 12 cc |

| | |
|---|---|
| Ethylene glycol | 10 g |
| 1-hydroxyethylidene-1,1-diphosphonic acid | 2.5 g |
| Bismuth chloride | 0.2 g |
| Zinc sulfate, heptahydrate | 0.7 g |
| Ammonium hydroxide, (in an aqueous 28% solution) | 2.0 g |
| Polyvinyl pyrrolidone (K-17) | 0.2 g |
| Fluorescent whitening agent, (a 4,4'-diaminostilbene diphosphonic acid derivative) | 2.0 g |
| Add water to make in total | 1 liter |
| Adjust pH to be | pH 7.5 |

The stabilizing treatments were carried out in a double-tank structured counter-current system.

Dot gain ($DG_{50}$) of a 50% halftone dot image was calculated out of the following Murray-Davies equation, after measuring the solid density (Dt), 50% halftone dots ($D_{50}$) and white background (Db) each of the half tone dots having 133 lines per inch, by making use of an X-rite.

$$DG_{50} = \frac{1 - 10^{(Db - Dt)}}{1 - 10^{(Db - D_{50})}} X 100 - 50$$

Table 1

| Sample No. | Exposure amount (%) | Gradation Y | Gradation M | Gradation C | Reflection density (nm) 450 | Reflection density (nm) 500 | Reflection density (nm) 700 | Dot gain * Y 19 - 25 | Dot gain * M 19 - 25 | Dot gain * C 19 - 25 | Dot gain * K 19 - 25 | White background Y | White background M | White background C | White background K | Large dot reproducibility | Small dot reproducibility | Image quality | Remarks |
|---|---|---|---|---|---|---|---|---|---|---|---|---|---|---|---|---|---|---|---|
| P-1 | 125<br>100<br>75 | 3.3 | 3.7 | 2.7 | 1.10 | 1.01 | 1.00 | 15<br>22<br>26 | 15<br>22<br>26 | 17<br>22<br>26 | 17<br>22<br>26 | 0.17<br>0.21<br>0.26 | 0.16<br>0.23<br>0.30 | 0.16<br>0.20<br>0.23 | 0.16<br>0.20<br>0.24 | ○<br>△<br>× | ○<br>○<br>○ | △<br>×<br>×× | Comp. |
| P-2 | 125<br>100<br>75 | 2.9 | 2.9 | 3.3 | 0.54 | 0.40 | 0.78 | 18<br>22<br>26 | 18<br>22<br>26 | 18<br>22<br>26 | 18<br>22<br>26 | 0.16<br>0.17<br>0.19 | 0.15<br>0.16<br>0.17 | 0.16<br>0.16<br>0.17 | 0.16<br>0.16<br>0.18 | △<br>×<br>× | ×<br>×<br>△ | ××<br>×<br>×× | Comp. |
| P-3 | 125<br>100<br>75 | 2.6 | 2.2 | 2.1 | 1.08 | 1.00 | 1.01 | 16<br>20<br>24 | 18<br>22<br>26 | 18<br>22<br>26 | 17<br>22<br>25 | 0.16<br>0.17<br>0.18 | 0.15<br>0.16<br>0.17 | 0.15<br>0.16<br>0.16 | 0.16<br>0.16<br>0.17 | ○<br>○<br>○ | ○<br>○<br>○ | △<br>○<br>○ | Inv. |
| P-4 | 125<br>100<br>75 | 1.5 | 1.6 | 1.6 | 1.09 | 1.01 | 1.00 | 22<br>26<br>33 | 21<br>26<br>32 | 22<br>26<br>32 | 23<br>28<br>35 | 0.17<br>0.21<br>0.26 | 0.16<br>0.23<br>0.30 | 0.16<br>0.20<br>0.23 | 0.16<br>0.20<br>0.24 | ×<br>×<br>× | ×<br>×<br>× | ××<br>×<br>×× | Comp. |
| P-5 | 125<br>100<br>75 | 1.8 | 1.9 | 2.2 | 1.09 | 1.01 | 1.00 | 19<br>23<br>26 | 19<br>23<br>25 | 18<br>22<br>25 | 19<br>23<br>26 | 0.16<br>0.17<br>0.18 | 0.15<br>0.16<br>0.17 | 0.15<br>0.16<br>0.16 | 0.16<br>0.16<br>0.17 | △<br>○<br>△ | ○<br>○<br>○ | ○<br>○<br>○ | Inv. |
| P-6 | 125<br>100<br>75 | 2.6 | 2.7 | 2.6 | 1.09 | 1.01 | 1.00 | 17<br>21<br>26 | 16<br>21<br>24 | 16<br>21<br>25 | 18<br>21<br>25 | 0.16<br>0.17<br>0.18 | 0.15<br>0.16<br>0.17 | 0.15<br>0.16<br>0.16 | 0.16<br>0.16<br>0.17 | △<br>○<br>△ | ○<br>○<br>○ | ○<br>◎<br>○ | Inv. |
| P-7 | 125<br>100<br>75 | 2.3 | 2.2 | 2.1 | 1.10 | 1.01 | 1.00 | 18<br>22<br>26 | 18<br>22<br>26 | 18<br>22<br>26 | 18<br>22<br>26 | 0.16<br>0.17<br>0.18 | 0.15<br>0.16<br>0.17 | 0.15<br>0.16<br>0.16 | 0.16<br>0.16<br>0.17 | ○<br>○<br>△ | ○<br>○<br>○ | ○<br>◎<br>○ | Inv. |

Comp.: Comparison    Inv.: Invention

* The values appeared on the uppermost lines of each column indicate the standard values of the corresponding printed matter.

<Large dot reproducibility>

Large dots of 97% were observed with the eye.

○ : large dots of 97% could be reproduced;
Δ : large dots of 97% were slightly damaged;
× : large dots of 97% were damaged.

<Small dot reproducibility>

Small dots of 3% were observed with the eye.
○ : Small dots of 3% could be reproduced;
Δ : Small dots of 3% were scratched;
× : Small dots of 3% were not reproduced at all.

<Image quality>

Image qualities for proof print were comprehensively evaluated with the eye.
◎ : Image qualities were excellent;
○ : Image qualities were good;
Δ : Image qualities were slightly unsatisfactory for checking up the gradation;
× : Image qualities were satisfactory for checking up the plates, but not satisfactory for checking up for the gradation;
×× : Not applicable to check up the plates.

As is obvious from Table 1, the white background and large dot reproducibility were deteriorated when the dot gain was tried to be adjusted by changing the exposure amounts, and the large dot reproducibility and small dot reproducibility were deteriorated when the dot gain was tried to be adjusted by changing the image sharpness. However, the dot gain was satisfactorily adjusted by changing the gradation, without any deterioration of the white background, large dot reproducibility and small dot reproducibility.

Example 2

A negative type photosensitive material for color proofing use was prepared by coating the following layers 1 through 7 on the front surface of the (130μm-thick) paper support coated with polyethylene containing titanium oxide and then by coating a backing layer on the back surface thereof coated with polyethylene, respectively. The resulting photosensitive material is herein called Sample N-1.

The amounts of the additives coated thereon are indicated by $g/m^2$, and the amounts of the silver halide emulsions used therein are indicated by the amounts converted into the silver contents thereof.

| Layer | Composition | Amount coated |
|---|---|---|
| Layer 7 (A protective layer) | | |
| | Gelatin | 1.0 |
| | Silica (having an average particle size of 3μm) | 0.03 |
| | Antistaining agent (HQ-2) | 0.01 |
| | Antistaining agent (HQ-3) | 0.01 |
| Layer 6 (An interlayer) | | |
| | Gelatin | 0.4 |
| | UV absorbent (UV-1) | 0.2 |
| | UV absorbent (UV-2) | 0.2 |
| | UV absorbent (UV-3) | 0.2 |
| | Antistaining agent (HQ-1) | 0.01 |
| | SO-3 | 0.2 |
| | PVP | 0.2 |
| | Anti-irradiation dye (AI-3) | 0.07 |
| Layer 5 (A red-sensitive layer) | | |
| | Gelatin | 1.3 |
| | Red-sensitive silver chlorobromide emulsion spectrally sensitized with sensitizing dye (D-4) containing Br of 80 mol% and Cl of 20 mol%) | 0.22 |
| | Cyan coupler (C-1) | 0.3 |
| | Solvent (SO-1) | 0.15 |
| | Antistaining agent (HQ-) | 0.02 |
| Layer 4 (An interlayer) | | |
| | Gelatin | 0.6 |
| | Antistaining agent (HQ-1) | 0.01 |

| | |
|---|---|
| Antistaining agent (HQ-2) | 0.01 |
| Solvent (SO-3) | 0.2 |
| Anti-irradiation dye (AI-4) | 0.01 |
| Layer 3 (A green-sensitive layer) | |
| Gelatin | 1.2 |
| Green-sensitive silver chlorobromide emulsion spectrally sensitized with sensitizing dye (D-5); (containing Br=80 mol%, Cl=20 mol%) | 0.35 |
| Magenta coupler (M-1) | 0.2 |
| Color tone controller (MY-1) | 0.08 |
| Antistaining agent (HQ-1) | 0.02 |
| Solvent (SO-1) | 0.4 |
| Layer 2 (An interlayer) | |
| Gelatin | 0.6 |
| Antistaining agent (HQ-1) | 0.02 |
| Solvent (SO-3) | 0.2 |
| Anti-irradiation dye (AI-5) | 0.03 |
| Layer 1 (A blue-sensitive layer) | |
| Gelatin | 1.2 |
| Blue-sensitive silver chlorobromide emulsion spectrally sensitized with sensitizing dye (D-6); (containing Br=80 mol%, Cl=20 mol%) | 0.35 |
| Yellow coupler (Y-1) | 0.4 |
| Antistaining agent (HQ-1) | 0.02 |
| Solvent (SO-1) | 0.38 |
| Backing layer | |
| Gelatin | 6.0 |
| Silica (having an average particle size of 3μm) | 0.1 |

Wherein (SA-1) and (SA-2) were each used for the coating aids applied to the emulsion layer side and to

the backing layer side, and (H-1) and (H-2) were each used for the layer hardeners.

HQ-3 : 2-hexadecenyl-5-methyl hydroquinone

SO-3 : Di-i-decyl phthalate

MY-1

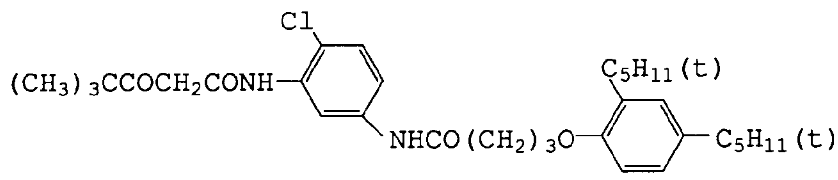

D-4

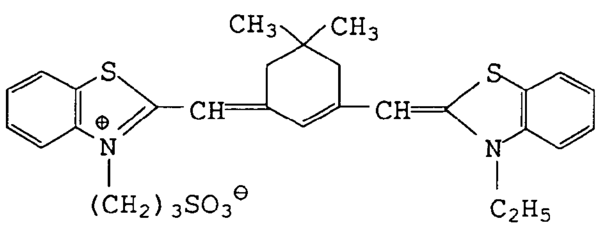

D-5

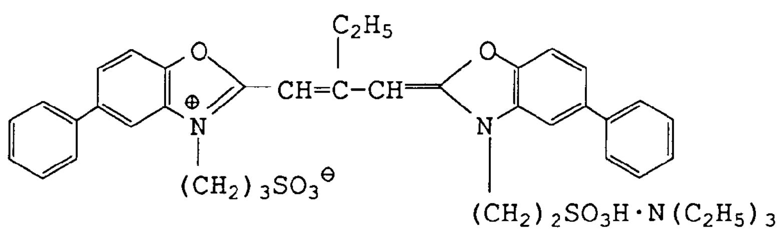

D-6

The same as D-1

UV-3

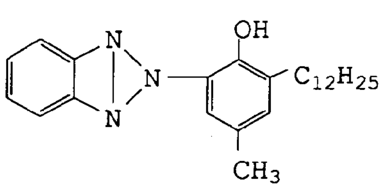

AI-3

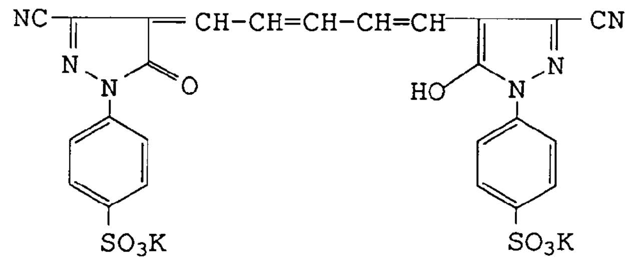

AI-4

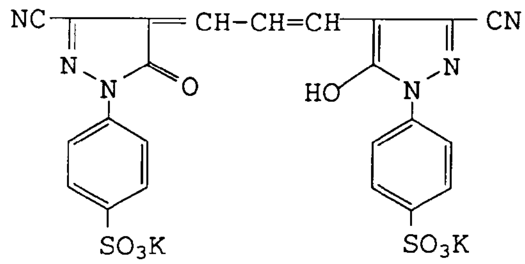

AI-5

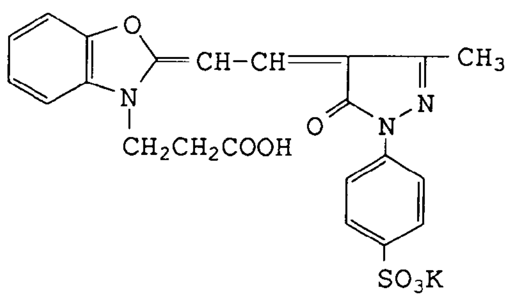

Samples N-2 through N-7 were each prepared by varying the average particle sizes of Y, M and C of Sample N-1 as shown in Table 2, respectively.

The resulting samples were each exposed to light in an ordinary method and were then processed in the following processing steps.

| Processing step-2 | Time | Temperature |
|---|---|---|
| Color developing | 2 min. | 39°C |
| Bleach-fixing | 45 sec. | 33°C |
| Stabilizing | 1min.30sec. | 33°C |
| Drying | 1 min. | 70°C |

(Color developer)

| | |
|---|---|
| Benzyl alcohol | 20 cc |
| Cerium (III) sulfate | 0.015 g |
| Ethylene glycol | 8 cc |
| Potassium sulfite | 2.5 g |
| Potassium bromide | 0.6 g |
| Sodium chloride | 0.2 g |
| Potassium carbonate | 25.0 g |
| T-1 | 0.1 g |
| Hydroxylamine sulfate | 5.0 g |
| Sodium diethylene triamine pentaacetate | 2.0 g |
| 4-amino-N-ethyl-N-(β-hydroxyethyl) aniline sulfate | 5.0 g |
| Brightening agent (4,4'-diaminostilben disulfonate derivative) | 1.0 g |
| Potassium hydroxide | 2.0 g |
| Diethylene glycol | 15 cc |
| Add water to make in total | 1 liter |
| Adjust pH to be | pH 10.15 |

(Bleach-fixer)

| | |
|---|---|
| Ferric ammonium diethylene triamine pentaacetate | 90 g |

| | |
|---|---|
| Diethylene triamine pentaacetic acid | 3 g |
| Ammonium thiosulfate, (in an aqueous 70% solution) | 180 cc |
| Ammonium sulfite, (in an aqueous 40% solution) | 27.5 cc |
| 3-mercapto-1,2,4-triazole | 0.15 g |
| Adjust pH with potassium carbonate or glacial acetic acid to be | pH 7.1 |
| Add water to make in total | 1 liter |

(Stabilizer)

| | |
|---|---|
| o-phenyl phenol | 0.3 g |
| Potassium sulfite, (in an aqueous 50% solution) | 12 cc |
| Ethylene glycol | 10 g |
| 1-hydroxyethylidene-1,1-diphosphonic acid | 8.0 g |
| Zinc sulfate, heptahydrate | 0.7 g |
| Add water to make | 1 liter |
| Adjust pH with ammonium hydroxide or sulfuric acid to be | pH 7.5 |

Each of the characteristic values of the processed samples was measured in the same manner as in Example 1. The results thereof will be shown in Table 2.

Table 2

| Sample No. | Exposure amount (%) | Gradation Y | Gradation M | Gradation C | Reflection density (nm) 450 | Reflection density (nm) 500 | Reflection density (nm) 700 | Dot gain * Y 19 - 25 | Dot gain * M 19 - 25 | Dot gain * C 19 - 25 | Dot gain * K 19 - 25 | White background Y 0.96 - 1.09 | White background M 1.31 - 1.44 | White background C 1.20 - 1.37 | White background K 1.50 - 1.60 | Large dot reproducibility | Small dot reproducibility | Image quality | Remarks |
|---|---|---|---|---|---|---|---|---|---|---|---|---|---|---|---|---|---|---|---|
| N-1 | 75<br>100<br>125 | 2.9 | 2.9 | 3.3 | 1.01 | 1.10 | 1.05 | 18<br>22<br>26 | 18<br>22<br>26 | 18<br>22<br>26 | 18<br>22<br>26 | 0.99<br>1.06<br>1.10 | 1.45<br>1.53<br>1.66 | 1.58<br>0.69<br>1.75 | 1.52<br>0.63<br>1.70 | ○<br>×<br>×× | ○<br>○<br>○ | △<br>×<br>×× | Comp. |
| N-2 | 75<br>100<br>125 | 2.9 | 2.9 | 3.3 | 0.50 | 0.55 | 0.82 | 18<br>22<br>26 | 18<br>22<br>26 | 18<br>22<br>26 | 18<br>22<br>26 | 0.90<br>1.00<br>1.09 | 1.32<br>1.37<br>1.44 | 0.30<br>1.38<br>1.42 | 1.47<br>1.52<br>1.58 | △<br>○<br>× | ×<br>△<br>△ | ××<br>×<br>×× | Comp. |
| N-3 | 75<br>100<br>125 | 1.5 | 1.6 | 1.6 | 1.01 | 1.10 | 1.05 | 20<br>25<br>32 | 21<br>26<br>33 | 20<br>26<br>33 | 20<br>26<br>33 | 0.71<br>1.01<br>1.12 | 1.10<br>1.38<br>1.45 | 1.09<br>1.38<br>1.42 | 1.30<br>1.52<br>1.57 | ○<br>○<br>△ | ××<br>×<br>× | ×<br>×<br>× | Comp. |
| N-4 | 75<br>100<br>125 | 1.8 | 1.9 | 2.2 | 1.01 | 1.10 | 1.05 | 19<br>24<br>26 | 18<br>24<br>26 | 18<br>23<br>25 | 19<br>23<br>26 | 0.90<br>1.01<br>1.12 | 1.32<br>1.38<br>1.45 | 1.21<br>1.38<br>1.42 | 1.46<br>1.52<br>1.57 | ○<br>○<br>△ | ○<br>○<br>○ | ○<br>○<br>○ | Inv. |
| N-5 | 75<br>100<br>125 | 2.1 | 2.5 | 2.6 | 1.01 | 1.10 | 1.05 | 18<br>22<br>26 | 17<br>22<br>25 | 17<br>21<br>25 | 18<br>22<br>25 | 0.91<br>1.02<br>1.11 | 1.32<br>1.38<br>1.45 | 1.21<br>1.37<br>1.42 | 1.44<br>1.52<br>1.58 | ○<br>○<br>△ | ○<br>○<br>○ | ○<br>○<br>○ | Inv. |
| N-6 | 75<br>100<br>125 | 2.4 | 2.6 | 2.6 | 1.01 | 1.10 | 1.05 | 18<br>21<br>25 | 17<br>21<br>25 | 17<br>21<br>25 | 17<br>21<br>26 | 0.91<br>1.02<br>1.11 | 1.32<br>1.38<br>1.45 | 1.21<br>1.37<br>1.42 | 1.44<br>1.52<br>1.58 | ○<br>○<br>△ | ○<br>○<br>○ | ○<br>◎<br>○ | Inv. |
| N-7 | 75<br>100<br>125 | 2.3 | 2.2 | 2.1 | 1.01 | 1.10 | 1.05 | 18<br>22<br>26 | 18<br>22<br>26 | 18<br>22<br>26 | 18<br>22<br>26 | 0.90<br>1.01<br>1.12 | 1.32<br>1.38<br>1.45 | 1.21<br>1.38<br>1.42 | 1.46<br>1.52<br>1.57 | ○<br>○<br>△ | ○<br>○<br>○ | ○<br>◎<br>○ | Inv. |

Comp.: Comparison Inv.: Invention

* The values appeared on the uppermost lines of each column indicate the standard values of the corresponding printed matter.

<Color reproducibility>

Evaluation was made in terms of 4 grades with the eye.

○ : Color hue resembled that of the corresponding printing ink;
Δ : Color hue was slightly different from that of the corresponding printing ink;
× : Color hue was different from that of the corresponding printing ink;
×× : Color contamination was produced.

<Small dot reproducibility>

The same evaluation criteria were applied as in Example 1.

<Image quality>

The same evaluation criteria were applied as in Example 1.

As is obvious from Table 2, the color reproducibility was deteriorated when the dot gain was tried to be adjusted by changing the exposure amounts, and the small dot reproducibility was seriously deteriorated when the dot gain was tried to be adjusted by changing the image sharpness. However, the method in which the dot gain is satisfactorily adjusted by changing the gradation, the color reproducibility and halftone dot reproducibility are each satisfactorily compatible. Therefore, this method is the most effective.

## Advantages of the Invention

According to the invention, it can be achieved to obtain a color proof excellent in image quality, color reproducibility and halftone dot reproducibility based upon a color-separated halftone dot image information, by making use of a silver halide color photographic photosensitive material.

## Claims

1. A method for preparing a color proof by subjecting a silver halide color photographic photosensitive material comprising a reflective support having thereon a blue-sensitive layer, a green-sensitive layer and a red-sensitive layer to light exposure and processing based on halftone dot image information comprised of yellow, magenta, cyan and black image information, wherein at least one of the photosensitive layers has an average gradation of 1.7 to 2.8 between a density of a minimum density + 0.5 and another density of the minimum density + 1.1.

2. The method of claim 1, wherein said color photographic material has a reflection density of not lower than 0.8 at each of wavelengths of 450nm, 550nm and 700nm before processing said color photographic material.

3. The method of claim 2, wherein said reflection density is within a range of 0.9 to 1.2.

4. The method of claim 1, wherein said photographic material has an antihalation layer on the support.

European Patent Office

# EUROPEAN SEARCH REPORT

Application Number
EP 93 30 7864

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| X | US-A-4 994 350 (OGAWA ET AL.)<br>* column 1, line 53 - line 54 *<br>* column 21, line 33 - column 22, line 57 *<br>* column 29; table 1 *<br>* figure 1 *<br>----- | 1-4 | G03C7/30<br>G03F3/10 |

TECHNICAL FIELDS SEARCHED (Int.Cl.5)
G03C
G03F

The present search report has been drawn up for all claims

| Place of search | Date of completion of the search | Examiner |
|---|---|---|
| THE HAGUE | 24 November 1993 | Magrizos, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)